# EUROPEAN PATENT APPLICATION

(11) **EP 0 705 914 A1**
(43) Date of publication of application: **10.04.1996**
(21) Application number: 95306488.8
(22) Date of filing: 14.09.1995
(51) Int. Cl.: C23C 16/20, C23C 16/56, F01N 3/24, C23C 10/08

(54) **Method for applying aluminum coating to fabricated catalytic exhaust system component**

(30) Priority: 06.10.1994 US 319205
(71) Applicant: ALLEGHENY LUDLUM CORPORATION, Pittsburgh Pennsylvania 15222-5479 (US)
(72) Inventor: Larsen, James Martin, Battlecreek, Michigan 49015 (US); Sorace, Dominic Alfred, Sarver, Pennsylvania 16055 (US); Franson, Ivan Anders, Saxonburg, Pennsylvania 16056 (US)
(74) Representative: Gilding, Martin John

(57) **Abstract**

A method is provided for forming a component used in hot waste gas exhaust systems, such as for automotive catalytic converters (10), including selecting an alloyed steel sheet, such as stainless steel, forming the component, coating with aluminum by thermally decomposing a gaseous mixture comprising an aluminum-bearing compound, such as triethyl aluminum and trimethyl aluminum, and a carrier gas, such as argon, nitrogen, and helium, then heating the aluminum of the coating to corrosively protect the exhaust component by either oxidizing the aluminum to form an alumina layer, or diffusing aluminum into the steel, or both.

## Description

### BACKGROUND OF THE INVENTION

### 1. Field of the Invention:

The present invention relates to a method for providing a coating of alumina to metallic structures which operate at high temperatures to conduct waste exhaust gases. More particularly, the present invention relates to contacting a metal substrate used to form catalytic converters and exhaust pipes with a gaseous mixture_to form an aluminum coating on exposed surfaces of these structures and either oxidizing the surface of the aluminum coating to form alumina or heat treating to form a diffusion layer of aluminum within the metal substrate, or both.

### 2. Description of the Prior Art:

Isothermal oxidation resistance of Fe-Cr-Al alloy foils or sheets is controlled in large measure by the bulk level of aluminum in the alloy. The alloy is considered protected as long as the oxidation product is alpha-(Al,Cr)₂O₃. The growth kinetics for the growth of this oxide are parabolic, and the related rate of weight gain per unit area decreases proportionally with the square root of time. When the aluminum level in the alloy is depleted through oxide growth to a point at which unprotective spinal oxides begin forming, significantly accelerated weight gain is measured and this behavior is termed "breakaway oxidation" and the time at which it begins is known as "breakaway time". At a given rate of Al₂O₃ growth, breakaway time can be lengthened simply by increasing the bulk aluminum level in the alloy to delay critical aluminum depletion. However, above certain levels which also depend on the chromium concentration, these alloys become increasingly brittle and eventually unfabricable. For 20 wt.% chromium alloys, the upper limit of aluminum for a wrought product is roughly 5.5 weight percent.

Catalytic converters and associated ducts and gas conducting pipes experience severe service life limitations due to the required operating temperatures and the corrosive nature of the gases which contact the structure. Coating the parts of the catalytic structure and the gas supply duct work with aluminum and subsequently oxidizing the aluminum is a good way to improve the oxidation behavior of the assembly. However, coating prior to core fabrication could be potentially problematic because corrugating, wrapping, and welding/brazing of the metal may locally disturb or remove the coating. A better way is to fabricate the core and then coat all internal surfaces with aluminum. Most traditional methods of surface treatment, such as ion implantation, plasma spray, and physical vapor deposition, require line-of-sight conditions, and would therefore not be suited for this application. Other methods that do not require line-of-sight, such as metal-organic chemical vapor deposition (MOCVD), require very expensive facilities, in part, because of extreme health-related precautions.

In March, 1992 issue of "Advanced Coatings & Surface Technology", a method for depositing aluminum coatings with a ternary gas mixture by reacting either trimethyl aluminum (TMA) or triethyl aluminum (TEA) with hydrogen and argon at fairly low temperatures (400 to 800°C) was briefly described. This was more fully described in a paper entitled "Oxidation Protection of Mild Steel by Coatings Made With Aluminum Alkyls" by A.L. Cabrera et al in Oxidation of Metals, Vol. 36, pp. 265-280, No. 3/4, 1991.

The use of triethyl aluminum or trimethyl aluminum with hydrogen and argon gas as a gaseous mixture is proposed in the present invention to improve the oxidation resistance of automotive exhaust components, e.g., catalytic converters, and associated duct work without the necessity of requiring an aluminum-bearing metal or increasing the bulk aluminum level, if any, of the metal alloy. The use of the gaseous mixture would benefit the forming of components used in the exhaust system provided that the initial protective alumina coating is formed. This effectively would increase the aluminum content of the assembly without depletion of aluminum from the aluminum-bearing base metal and without the problems associated with actually increasing the bulk aluminum alloy content. The coating with the gaseous mixture also may remove the necessity of "whiskering" the alloy and adding an alumina wash coat prior to depositing the catalytic precious metal coating. This benefit may be particularly important in lowering overall production costs of exhaust components and improving catalytic efficiencies.

By exercising satisfactory thickness control to the coating layer of aluminum, a thinner base metal gauge can be more easily used for electrically-heated "light-off" automotive catalytic converters as a result of improved oxidation resistance. The alumina coating which would be formed in this manner is extremely adherent whereby metal alloys with lower bulk aluminum levels can be used without loss of oxidation resistance as compared to the nominal 5% Al alloys currently used without surface treatment. In this way the product can be more readily produced and at less cost. The method would provide an economical way to produce an exhaust component, for example, at a nominal thickness of 0.0015 inch (0.038 mm), which has been identified as a target thickness for the light-off automotive converter core material.

Accordingly, it is an object of the present invention to provide a method for improving corrosion resistance and/or lessening the wall thickness requirement for a component for use in an exhaust system to conduct hot waste gases in which the component, sub-assembly or assembly thereof receives a coating of aluminum to be subsequently reacted to form alumina on the surface or to diffuse into the metal substrate.

### SUMMARY OF THE INVENTION

More particularly according to the present invention there is provided a method for forming a component for use in an exhaust system to conduct a hot waste gas stream, the method including the steps of selecting an alloyed steel sheet, which may include an aluminum alloying component, forming an exhaust component from the selected alloyed steel sheet, coating the exhaust component with aluminum by thermally decomposing a gaseous mixture comprising a carrier gas and an aluminum-bearing compound, preferably trimethyl aluminum or triethyl aluminum or mixtures thereof, and heating the aluminum of the coating to corrosively protect the exhaust component from corrosion, preferably to oxidize the aluminum or diffuse aluminum into the base metal, or both.

### BRIEF DESCRIPTION OF THE DRAWINGS

The present invention will be more fully understood when the following description is read in light of the accompanying drawings in which:
Figure 1 is an isometric illustration partly in section of a known catalytic converter design for an automotive internal combustion engine;
Figure 1A is an illustration of a known metallic catalytic core for a catalytic converter;
Figure 2 is a block diagram schematically illustrating the method of the present invention as applied to a batch type process;
Figure 3 is an elevational view partly in section illustrating a continuous process to carry out the method of the present invention; and
Figure 4 is an isometric illustration of a header system to carry out the method of the present invention.

### DETAILED DESCRIPTION OF THE PREFERRED EMBODIMENT

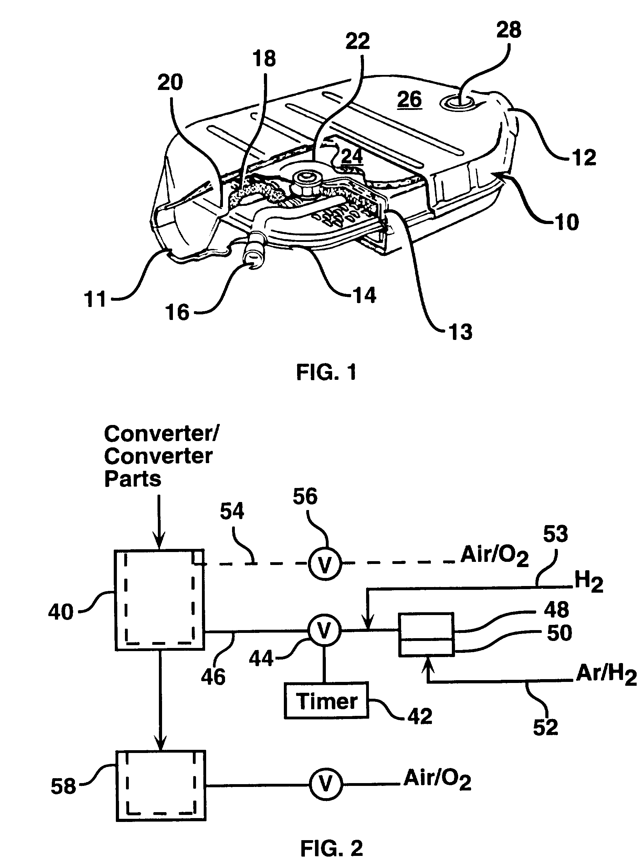

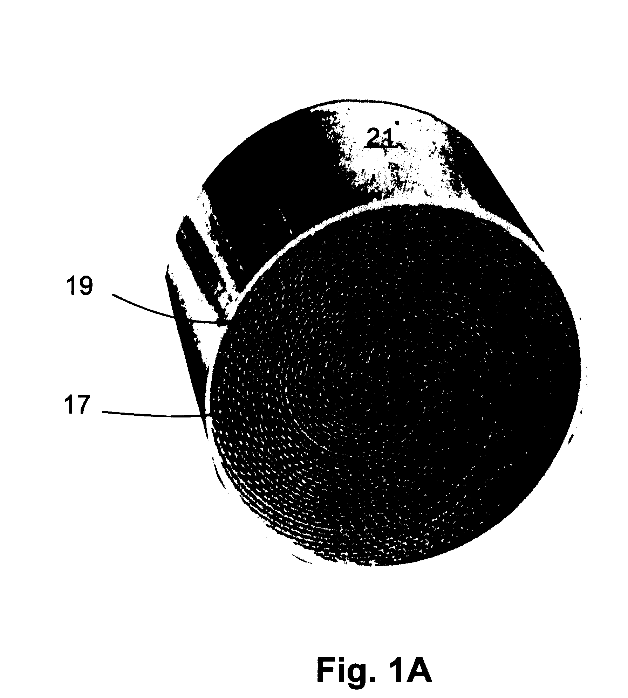

Figure 1 illustrates a prior art form of a catalytic converter 10 which includes an outer wrap having an inlet opening 11 and a delivery opening 12 for the flow of exhaust gases through a reaction chamber 13 wherein perforated sheets 14 are joined together about their outer periphery to form an air plenum that receives a supply of air by an inlet duct 16. The air migrates through the perforated openings in the sheets 14 into layers of catalysts 18 situated on opposite sides of the sheets within a retainer shell 20. The retainer shell is contained within a converter shell 22. Layers 24 of insulation are sandwiched between the converter shell 22 and an outer shell wrap 26. The outer shell wrap is formed as two halves that are joined together about a peripheral bead. A fill plug 28 seals aligned openings in the outer shell wrap 26, converter shell 22, and retainer 20 for installing suitable quantities of catalysis. The components of the catalytic converter are made through suitable forming operations using sheet stock material, such as stainless steel. The sheet stock may include aluminum as an alloying element in the steel.

Figure 1A illustrates a known metallic catalytic core 21 for a catalytic converter. The core is fabricated from metal substrate sheet stock and would be used instead of the pellet-type design of Figure 1. Generally, the core 21 includes a honeycomb structure 19 fabricated from metallic foil sheet stock as the metal substrate. When used in a catalytic converter, the exhaust gases flow through the honey combs 17 which serve as the primary reaction location to convert exhaust pollutants.

The present invention would be equally applicable to other metallic catalytic converters used in both on- and off-highway vehicles, two cycle internal combustion engines such as lawn mowers, and in metal catalytic converters for power plants, co-generation units, food industry applications and other stationary devices. The invention would also apply to allied structure such as tailpipes or duct work used to feed hot waste gases to and from such metallic catalytic converters. While the invention would be found useful for coating aluminum-bearing metals, such coatings may be applied to assemblies and sub-assemblies, where non-aluminum-bearing metals are used, or where, for example, welds and brazing alloys containing non-aluminum-bearing alloys which compose a portion of the component parts are used.

In carrying out the method of the present invention, the gaseous mixture is important. The coating layer of aluminum primarily would be obtained from aluminum-bearing compounds, preferably trimethyl aluminum (TMA) and triethyl aluminum (TEA). For the present invention, the aluminum-bearing compound is selected from the group of TMA, and TEA, or mixtures of TMA and TEA. Carrier gases selected from the group of nonreactive gases such as argon, nitrogen, and helium may be used, preferably argon. Also, to control the moisture in the gaseous mixture, a dry gas, such as hydrogen, preferably would be used to lower the dew point of the mixture. In a preferred embodiment, the gaseous mixture comprises an aluminum-bearing compound of TMA, or TEA, or mixture of TMA and TEA, a carrier gas of argon, and dry hydrogen gas.

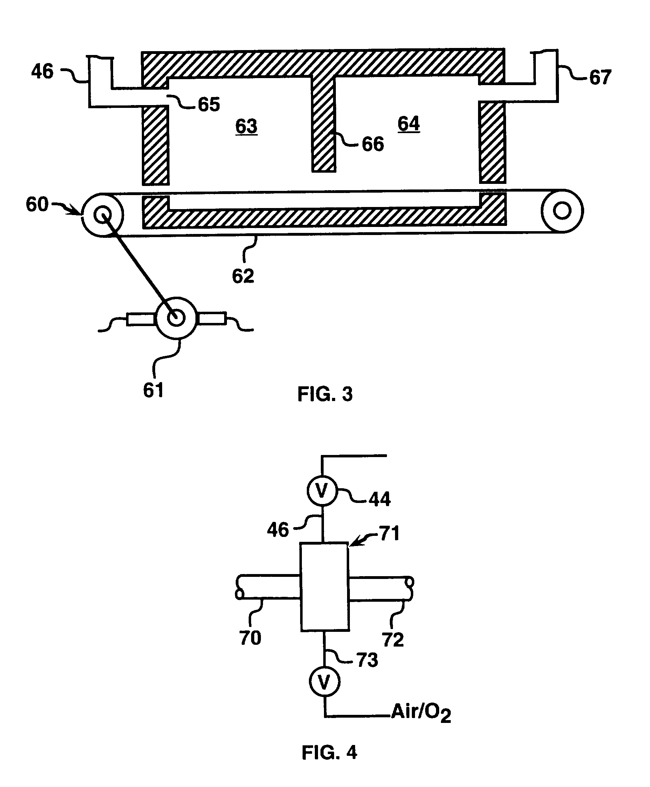

In Figure 2 the method of the present invention is illustrated as an application to a batch process in which a furnace 40 would be heated by electric or gas firing to a temperature in the range of 400° to 800° C. Metallic catalytic converter components, assemblies and/or sub-assemblies would be loaded onto trays or other suitable support structure that are placed in the furnace for the necessary treatment time that could be controlled by a timer 42. The timer may be used by an operator to control a flow valve 44 for the delivery of a gaseous mixture in a line 46 extending to the furnace chamber. The gaseous mixture would form in a vessel 48 having a bath 50 of trimethyl aluminum or triethyl aluminum. A conduit line 52 would supply argon gas to a bubble plate or other device to incrementally mix the incoming gas with the bath 50. Dry hydrogen 53 would be introduced to the Ar and TMA or TEA stream prior to valve 44 to render the gaseous mixture thermodynamically reducing with respect to the aluminum coating and the coated steel.

The volume in the vessel above the bath would form a supply area for the argon and TMA or TEA. The time which the exhaust component in the furnace would be exposed to the gaseous mixture would be varied to produce the desired thickness to the aluminum that would be deposited on the metal surface of the exhaust component.

After the aluminum coating has obtained a desired thickness, valve 44 could be operated to terminate the supply of the gaseous mixture. The atmosphere in the furnace, if desired, can be controlled when gas fired or through the external supply of an oxidizing gas, such as air or oxygen, in supply line 54 through operation of valve 56 to produce an oxidizing atmosphere to oxidize the aluminum of the coating to form a layer of alumina.

As an alternative to oxidizing the aluminum surface of the coating in the furnace 40, the tray containing the exhaust components could be placed into a reaction furnace 58 supplied 'with an oxidizing gas to maintain a suitable atmosphere for carrying out the oxidation of the surface of the aluminum coating. The use of the reaction furnace in the batch process would increase the throughput rate in the furnace 40.

The step of heating the aluminum of the coating could be used to diffuse aluminum into the base metal of the steel sheet from which the component would be formed. This would benefit the isothermal oxidation resistance of the Fe-Cr or Fe-Cr-Al alloy foils or sheets by increasing the bulk level of aluminum in the alloy. Furthermore, the step of heating could result in both oxidizing and diffusing the aluminum in the coating to enhance the corrosion protection of the component.

For greater production rates, Figure 3 illustrates a continuous process for depositing an aluminum layer using this technique. A belt conveyor 60 driven by a motor 61 would control the dwell time for exhaust components that are placed on the belt 62 and transported thereby through each of successively arranged furnace chambers 63 and 64. Furnace chamber 63 has an opening 65 to which there is secured a duct 46 for delivering quantities of the gaseous mixture to maintain an effective atmosphere in chamber 63 at a temperature of between 400° and 600°C by gas firing or electric heating. Under these conditions, the exhaust component would attain a build-up of aluminum on the exposed surfaces of exhaust components to a desired thickness before the components pass a partitioning wall 66 into furnace chamber 64.

Chamber 64 would provide the heating necessary to oxidize and/or diffuse the aluminum. For example, chamber 64 could be maintained with an oxidizing atmosphere that can be supplied by atmospheric air or other sources of oxidizing gases through conduit 67.

The method of the present invention contemplates heating the component either prior to or in the presence of the gaseous mixture containing an aluminum compound. For example, the component could be preheated in a furnace, or heated in the presence of the gaseous mixture. Heating may be resistance heating, such as using electrical leads to electrically heat the exhaust component, such as a catalytic converter core.

It is also within the scope of the present invention to provide a still further modified form of a system of applying a coating to an exhaust component which is shown in Figure 4. There is generally shown by identification numeral 70 a duct such as a tailpipe or a duct extending to a wholly assembled or subassembly of a catalytic converter. The duct 70 is connected to a header 71 which receives a stream of hot gases from a duct 72 at a temperature within the range of 400° to 800°C. The header also includes an opening to which there is connected duct 46 for delivering a gaseous mixture as described hereinbefore in regard to Figure 2. The header also could receive a supply of oxidizing gas such as air in a line 73 under control of a valve 74 which is operated to supply the oxidizing gas only after coating of aluminum to the desired thickness would be applied to the exposed surfaces contacted by the gases from the header.

The method of the present invention is suitable for the production of new components by original equipment manufacturers and for refurbishing used equipment. Although a catalytic converter is exemplified herein, the method is intended for use with various hot waste gas components, such as tailpipes, mufflers, exhaust manifolds and pipes, industrial exhaust gas stacks, catalytic converter parts, and the like.

While the present invention has been described in connection with the preferred embodiments of the various figures, it is to be understood that other similar embodiments may be used or modifications and additions may be made to the described embodiment for performing the same function of the present invention without deviating therefrom. Therefore, the present invention should not be limited to any single embodiment, but rather construed in breadth and scope in accordance with the recitation of the appended claims.

## Claims

1. A method for forming a component for use in an exhaust system to conduct a hot waste gas stream, said method including the steps of:
selecting an alloyed steel sheet;
forming an exhaust component from the selected alloyed steel sheet;
coating the exhaust component with aluminum by thermally decomposing a gaseous mixture comprising an aluminum-bearing compound and a carrier gas; and
heating the aluminum of the coating to corrosively protect the exhaust component from corrosion.

2. The method according to claim 1 wherein the step of heating oxidizes the aluminum of the coating to form a layer of alumina on the component.

3. The method according to claim 2 wherein said step of oxidizing the aluminum includes introducing the exhaust component having a deposited aluminum coating thereon in a furnace having an oxidizing atmosphere therein at a temperature sufficient to oxidize the surface of the coating.

4. The method according to claim 1 wherein the step of heating diffuses aluminum into the base metal sheet of the component.

5. The method according to claim 4 further including heating the aluminum coating to oxidize the aluminum to form a layer of alumina.

6. The method according to any one of the preceding claims further including forming the gaseous mixture externally of a furnace chamber and then introducing the gaseous mixture to the furnace to contact the exhaust component which is maintained at a temperature sufficient to react the gaseous mixture for depositing aluminum on the metallic surface of the exhaust component.

7. The method according to any one of the preceding claims wherein said step of coating includes introducing the exhaust component in a furnace and controlling the atmosphere and temperature in the furnace for coating the aluminum on the exhaust component.

8. The method of any one of the preceding claims wherein the aluminum-bearing compound is selected from the group of trimethyl aluminum, triethyl aluminum, and mixtures of trimethyl aluminum and triethyl aluminum.

9. The method according to any one of the preceding claims wherein the carrier gas is selected from the group of argon, nitrogen and helium.

10. The method according to any one of the preceding claims wherein the gaseous mixture further includes a drying gas.

11. The method according to any one of the preceding claims wherein said step of coating said exhaust component is carried out in an atmosphere at a temperature between 400° and 800°C.

12. The method according to any one of the preceding claims wherein the alloyed sheet includes an aluminum alloying element.

13. The method according to any one of the preceding claims wherein said alloy sheet metal formed is comprised of stainless steel.

14. The method according to any one of the preceding claims wherein said exhaust component comprises part of an automotive exhaust system.

15. The method according to any one of the preceding claims further including the step of continuously conveying said exhaust component in an open-ended furnace having coating and oxidizing chambers.

16. The method according to any one of the preceding claims further including the step of flowing the gaseous mixture through the exhaust component for said step of coating the exhaust component and for said step of oxidizing the aluminum of the coating.

17. The method according to any one of the preceding claims wherein said exhaust component comprises a sub-assembly of a fabricated catalytic converter having an outer shield housing and support member for catalytic converter.

18. The method according to any one of the preceding claims wherein said exhaust component includes a catalytic converter with electrical leads to electrically heat a catalytic converted core, and wherein said method includes the further step using said electrical leads to heat said electrical core to a temperature sufficient to decompose said gaseous mixture.

19. The method for producing an automotive exhaust system component, the method comprising:
selecting an aluminum-bearing steel in sheet or strip form;
forming an exhaust component from the steel;
coating the exhaust component with aluminum by thermally decomposing a gaseous mixture comprising an aluminum-bearing compound selected from the group of trimethyl aluminum, triethyl aluminum, and mixtures thereof, a carrier gas selected from the group of argon, nitrogen, and helium, and a drying gas; and thereafter
heating the aluminum of the coating to protect the exhaust component from corrosion by either oxidizing the aluminum of the coating to form a layer of alumina on the component, or diffusing aluminum into the steel, or both.
